# EUROPÄISCHE PATENTSCHRIFT

(11) **EP 1 508 583 B1**
(45) Veröffentlichungstag und Bekanntmachung des Hinweises auf die Patenterteilung: **11.10.2006**
(21) Anmeldenummer: 02733240.2
(22) Anmeldetag: 29.05.2002
(51) Int. Cl.: C08G 59/14, H01L 23/29, C08J 5/24

(54) **PHOSPHORHALTIGES EPOXIDHARZ, PHOSPHORHALTIGES EPOXIDHARZ ENTHALTENDE ZUSAMMENSETZUNG, HERSTELLUNGSVERFAHREN DAFÜR UND DICHTUNGSMASSE UND LAMINAT, JEWEILS DIESES ENTHALTEND ODER DAMIT HERGESTELLT**
PHOSPHORUS-CONTAINING EPOXY RESIN, PHOSPHORUS-CONTAINING EPOXY RESIN COMPOSITION, PROCESS FOR PRODUCING THE SAME, AND SEALING MATERIAL AND LAMINATE EACH COMPRISING OR MADE WITH THE SAME
RESINE EPOXY CONTENANT DU PHOSPHORE, COMPOSITION A BASE DE LADITE RESINE, PROCEDE DE FABRICATION, MATERIAU ET STRATIFIE D'ETANCHEIFICATION RENFERMANT CETTE RESINE OU FABRIQUEE A PARTIR DE CETTE RESINE

(43) Veröffentlichungstag der Anmeldung: 23.02.2005
(73) Patentinhaber: NIPPON CHEMICAL INDUSTRIAL COMPANY LIMITED, Tokyo 136-8515 (JP)
(72) Erfinder: TAMURA,K Nippon Chemical Ind.Co.,Ltd.Res.&Dev.HQ., 11-1, Kameido 9-chome (JP); HARA,Y Nippon Chemical Indust.Co.,Ltd.Res&Dev.HQ., 11-1, Kameido 9-chome (JP)
(74) Vertreter: Hinkelmann, Klaus
(86) Internationale Anmeldenummer: PCT/JP2002/005206
(87) Internationale Veröffentlichungsnummer: WO 2003/099900

(56) Entgegenhaltungen:
- EP-A- 1 167 417
- WO-A1-02/00667
- JP-A- 2002 241 466
- PATENT ABSTRACTS OF JAPAN Bd. 008, Nr. 034 (C-210), 15. Februar 1984 (1984-02-15) & JP 58 198521 A (TOSHIBA CHEMICAL KK), 18. November 1983 (1983-11-18)

## Beschreibung

### Hintergrund der Erfindung

### 1. Gebiet der Erfindung

Die vorliegende Erfindung betrifft ein Phosphor enthaltendes Epoxyharz, das in zahlreichen Materialien wie z. B. Abformverbindungen ("casting compounds"), Klebstoffen und elektrisch isolierender Farbe enthalten ist, das eine hohe Flammwidrigkeit besitzen; eine Phosphor enthaltende Epoxyharz-Zusammensetzung, die das Harz enthält und eine hohe Flammwidrigkeit besitzt; ein Verfahren zur Herstellung des Harzes; ein Dichtungsmittel, das zur Herstellung von elektrischen Komponenten benutzt wird und die Zusammensetzung enthält; ein Formmaterial, das die Zusammensetzung enthält; und ein Laminat wie z. B. ein mit Kupfer plattiertes Laminat, das in gedruckten Schaltkreisen ("printed wiring boards") oder elektrischen Schaltkreisen ("circuit boards") enthalten ist und die Zusammensetzung enthält.

### 2. Beschreibung des Standes der Technik

Epoxyharze werden aufgrund ihrer überlegenen Adhäsion, Hitzebeständigkeit und Formbarkeit für eine Vielzahl von Anwendungen verwendet wie z. B. elektronische Komponenten, elektrische Vorrichtungen, Fahrzeugkomponenten, FRPs und Sportartikel. Mit Kupfer plattierte Laminate und Dichtungsmittel für solche elektronischen Komponenten und elektrische Vorrichtungen enthalten ein Flammschutzmittel wie z. B. ein Halogenid oder eine Antimonverbindung. Jedoch sind die Halogenide und die Antimonverbindungen für menschliche Körper schädlich. Es wurde daher ein für die Umwelt verträgliches Flammschutzmittel gefordert.

Um Epoxyharze mit Flammwidrigkeit auszustatten, wurden bislang die folgenden Techniken vorgeschlagen: eine Technik, bei der ein Epoxyharz mit einem hinzugefügten Flammschutzmittel vermischt ("blended") wird, eine Technik, bei der ein Epoxyharz umgestaltet ("reformed") wird, indem chemisch an das Epoxyharz ein reaktives Flammschutzmittel gebunden wird, und ähnliche Techniken.

Beispiele für die Technik, die ein hinzugefügtes Flammschutzmittel benutzen, beinhalten zum Beispiel eine Technik, die in der ungeprüften Japanischen Patentanmeldung mit der Veröffentlichungsnummer 5-25369 offenbart ist, die wasserhaltiges Aluminiumoxid ("hydrated alumina") verwendet; eine Technik, die in der ungeprüften Japanischen Patentanmeldung mit der Veröffentlichungsnummer 58-198521 offenbart ist, die oberflächenbehandelten roten Phosphor, wasserhaltiges Aluminiumoxid und/oder Siliziumdioxidpulver benutzt; und eine Technik, die in der ungeprüften Japanischen Patentanmeldung mit der Veröffentlichungsnummer 63-156860 offenbart ist, in der modifizierter roter Phosphor verwendet wird.

Wenn Formmaterialien das hinzugefügte Flammschutzmittel enthalten, ist deren Formbarkeit unterlegen, da eine große Menge an Flammschutzmittel enthalten sein muss.

Andererseits kann bei der Verwendung eines reaktiven Flammschutzmittels der Gehalt an Flammschutzmittel niedrig sein. Daher wurden zahlreiche Techniken vorgeschlagen, die reaktive Flammschutzmittel verwenden.

Beispiele für derartige Techniken beinhalten eine Technik, die in der ungeprüften, unter der Nr. 57-195141 offengelegten japanischen Patentanmeldung offenbart ist, die Tris(hydroxypropyl)-phosphinoxid benutzt; eine Technik, die in der ungeprüften, unter der Nr. 63-95223 offengelegten Japanischen Patentanmeldung offenbart ist, die ein Phosphinoxidderivat benutzt; eine Technik, die in den ungeprüften, unter den Nummern 11-279258 and 11-166035 offengelegten japanischen Patentanmeldungen offenbart ist, die eine organische Phosphorverbindung verwenden; und eine Technik, die in den ungeprüften japanischen Patentanmeldungen mit den Offenlegungsnummern 51-143620, 3-84025, 2-272014 und 2-269730 offenbart ist, die Epoxyphosphat verwenden, das durch Reaktion von Phosphonsäure mit Epichlorhydrin oder einer Polyepoxyverbindung, die eine Epoxygruppe hat, hergestellt wurde. Das Phosphinoxidderivat wird durch die folgende Formel (3) dargestellt: 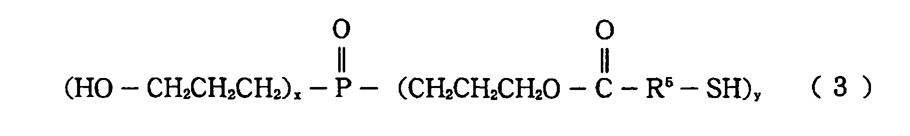 worin R⁵ eine Methylen- oder Ethylengruppe darstellt, x eine ganze Zahl von 0 bis 2 bedeutet, y eine ganze Zahl von 1 bis 3 darstellt und x + y = 3 ist. Die organische Phosphorverbindung wird durch die folgende Formel dargestellt: 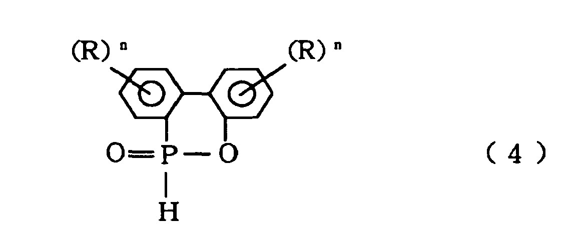 oder 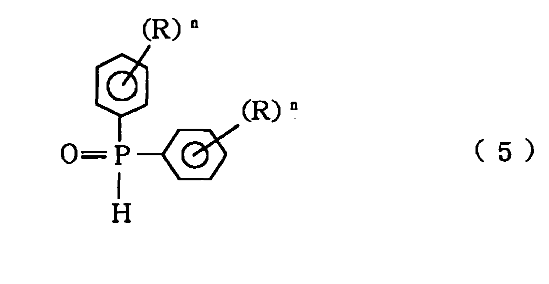 in der R eine Alkylgruppe mit einem bis sechs Kohlenstoffatomen bedeutet und n eine ganze Zahl von 0 bis 4 ist.

Eine Technik, die eine Phosphor enthaltende Verbindung benutzt, die als reaktives Flammschutzmittel funktioniert, ist in der ungeprüften japanischen Patentanmeldung mit der Offenlegungsnummer 2000-80251 offenbart. Diese Verbindung wird durch die folgende Formel (6) dargestellt: 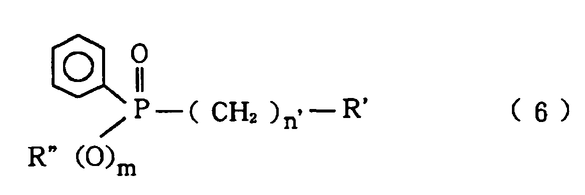 in der R' eine Gruppe mit zwei oder mehr phenolischen Hydroxylgruppen darstellt; n' eine ganze Zahl von 0 bis 3 ist; R" eine lineare oder verzweigte Alkylgruppe, eine Cyclohexylgruppe, Cyclopentylgruppe oder Arylgruppe mit einer bis acht Kohlenstoffatomen oder eine alkyl- oder alkoxysubstitutierte Alkyl- oder Arylgruppe mit einem bis 18 Kohlenstoffatomen ist und einen Ring haben kann, der ein Phosphoratom enthält; und m 0 oder 1 ist. In dieser Veröffentlichung sind zahlreiche Phosphor enthaltende Verbindungen offenbart, die als ein reaktives Flammschutzmittel funktionieren. Jedoch weist nur eine Verbindung mit einer Phosphor-Sauerstoff (P-O) - Bindung tatsächlich Flammwidrigkeit auf.

Wie oben beschrieben, wurden zahlreiche Techniken zur flammwidrigen Ausstattung von Epoxyharz vorgeschlagen. Jedoch gibt es bei den Techniken, die reaktive Flammschutzmittel verwenden, die folgenden Probleme: der Phosphorgehalt pro Gewichtseinheit im Epoxyharz kann nicht ausreichend erhöht werden, um die Flammwidrigkeit zu verleihen, und die Flammwidrigkeit kann nicht erhöht werden, selbst wenn dem Epoxyharz eine ausreichende Menge Phosphor zugesetzt wird.

Die meisten der bekannten organischen Phosphorverbindungen, die in den Flammschutzmitteln für das Epoxyharz enthalten sind, haben eine P-O-Bindung. Daher gibt es das Problem, dass solche Verbindungen hydrolysiert werden. Insbesondere gibt es das Problem, dass die elektrischen Eigenschaften von elektrischen Teilen durch ausgeflossene Phosphorsäure verschlechtert werden. Diese Phosphorsäure entsteht durch Zersetzung einer als Flammschutzmittel funktionierenden, eine P-O - Bindung aufweisenden organischen Phosphorverbindung, wenn die elektrischen Teile das Epoxyharz enthalten.

### Zusammenfassung der Erfindung

Die Erfinder haben gefunden, dass die oben genannten Probleme gelöst werden können und dadurch die Erfindung vollendet wird, wenn es einem Epoxyharz ermöglicht wird, eine strukturelle Einheit aufzuweisen, die von einem sekundären Phosphinderivat abgeleitet ist, das durch die unten beschriebene Formel (1) oder (2) dargestellt wird.

Demgemäss ist es eine Aufgabe der vorliegenden Erfindung, ein Phosphor enthaltendes Epoxyharz bereitzustellen, das eine hohe Flammwidrigkeit aufweist; ein Verfahren zur Herstellung des Harzes auf eine industriell vorteilhafte Art; eine Phosphor enthaltende Epoxyharz-Zusammensetzung, die das Harz enthält und eine hohe Flammwidrigkeit und eine hohe chemische Beständigkeit aufweist; ein Dichtungsmaterial, das die Zusammensetzung enthält; ein Formmaterial, das die Zusammensetzung enthält; und ein Laminat, das das Harz enthält.

In einem ersten Aspekt der vorliegenden Erfindung wird ein Phosphor enthaltendes Epoxyharz mit einer strukturellen Einheit bereitgestellt, die sich von einem sekundären Phosphinderivat ableitet, das durch die folgende Formel dargestellt wird: 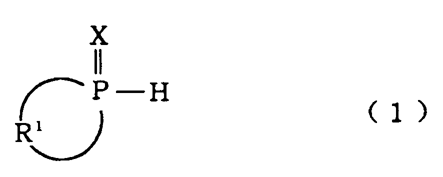 oder 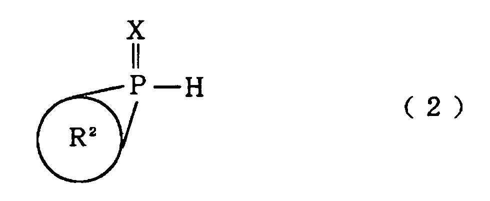 worin R¹ eine Alkylengruppe darstellt, die einen Substituenten aufweisen kann, R² eine Cycloalkylen- oder Arylengruppe darstellt, die einen Substituenten aufweisen kann, und X ein Sauerstoff- oder Schwefelatom darstellt.

Das sekundäre Phosphinderivat ist vorzugsweise mindestens eines, das unter 1,4-Cyclooktylenphosphinoxid und 1,5-Cyclooktylenphosphinoxid ausgewählt ist.

Das Phosphor enthaltende Epoxyharz wird vorzugsweise erhalten, indem es dem sekundären Phosphinderivativ ermöglicht wird, mit einer Epoxy- oder Polyepoxyverbindung zu reagieren.

Der Gehalt an Phosphor im Harz beträgt vorzugsweise 0.1 Gew.-% bis 10 Gew.-%.

In einem zweiten Aspekt der vorliegenden Erfindung wird eine Phosphor enthaltende Epoxyharz-Zusammensetzung bereitgestellt, die das Phosphor enthaltende Epoxyharz und ein Härtungsmittel oder einen Polymerisationsinitiator enthält.

In einem dritten Aspekt der vorliegenden Erfindung wird ein Verfahren zur Herstellung des Phosphor enthaltenden Epoxyharzes bereitgestellt, das den Schritt enthält, dass einer Epoxy- oder Polyepoxyverbindung die Reaktion mit einem sekundären Phosphinderivat ermöglicht wird, das durch die obige Formel (1) oder (2) dargestellt wird.

In einem vierten Aspekt der vorliegenden Erfindung wird ein Dichtungsmittel bereitgestellt, das die Phosphor enthaltende Epoxyharz-Zusammensetzung enthält.

In einem fünften Aspekt der vorliegenden Erfindung wird ein Formmaterial bereitgestellt, das die Phosphor enthaltende Epoxyharz-Zusammensetzung enthält.

In einem sechsten Aspekt der vorliegenden Erfindung wird ein Laminat bereitgestellt, das die Phosphor enthaltende Epoxyharz-Zusammensetzung enthält.

Das Phosphor enthaltende Epoxyharz der vorliegenden Erfindung weist eine überlegene Flammwidrigkeit auf und kann mit einem industriell vorteilhaften Verfahren hergestellt werden.

Die Phosphor enthaltende Epoxyharz-Zusammensetzung der vorliegenden Erfindung weist eine überlegene Flammwidrigkeit und chemische Beständigkeit auf. Die Zusammensetzung ist daher für die Herstellung von flammwidrigen Dichtungsmitteln, Formverbindungen ("molding compounds"), Abgussverbindungen ("casting compounds"), Klebstoffen und elektrisch isolierender Farbe für mit Kupfer plattierten Laminaten und elektrischen Komponenten, die in gedruckten Schalttafeln ("wiring boards") oder elektrischen Platinen enthalten sind, nützlich.

### Beschreibung der bevorzugten Ausführungsformen

Die vorliegende Erfindung wird nun im Detail beschrieben.

Ein Phosphor enthaltendes Epoxyharz, das durch die vorliegende Erfindung bereitgestellt wird, hat eine strukturelle Einheit, die sich von einem sekundären Phosphinderivat ableitet, das durch die folgende Formel dargestellt wird: 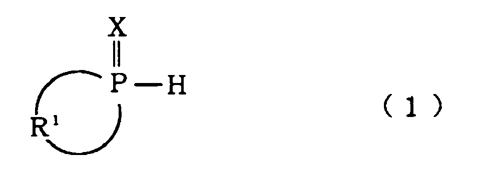 oder

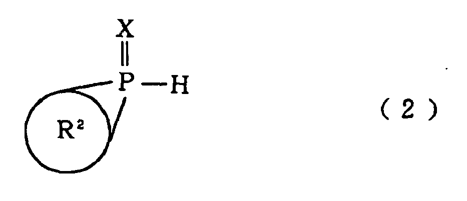

In Formel (1) bedeutet R¹ eine Alkylengruppe, die einen Substituenten aufweisen kann.

Die Alkylengruppe hat drei bis neun Kohlenstoffatome und vorzugsweise vier bis sechs Kohlenstoffatome. Beispiele für die Alkylengruppe beinhalten eine Propylengruppe, eine Butylengruppe, eine Pentamethylengruppe, eine Hexamethylengruppe, eine Heptamethylengruppe, eine Oktamethylengruppe und eine Nonamethylengruppe. Beispiele für den Substituenten beinhalten eine Phenylgruppe, eine Alkoxygruppe, eine Cyanogruppe und eine Hydroxylgruppe.

In der Formel (2) bedeutet R² eine Cycloalkylen- oder Arylengruppe, die einen Substituenten aufweisen kann.

Die Cycloalkylengruppe hat vier bis neun Kohlenstoffatome und vorzugsweise fünf bis sieben Kohlenstoffatome. Beispiele für die Cycloalkylengruppe beinhalten eine Cyclobutylengruppe, eine Cyclopentamethylengruppe, eine Cyclohexamethylengruppe, eine Cycloheptamethylengruppe, eine Cyclooktylengruppe und eine Cyclononylengruppe.

Beispiele für die Arylengruppe beinhalten eine Phenylengruppe und eine Naphthylengruppe. Beispiele für den Substituenten der Cycloalkylen- oder Arylengruppe beinhalten eine Phenylgruppe, eine Alkoxygruppe, eine Cyanogruppe und eine Hydroxylgruppe. Diese Substituenten können ein Heteroatom wie Sauerstoff, Schwefel oder Stickstoff enthalten.

In den Formeln (1) und (2) bedeutet X ein Sauerstoff- oder Schwefelatom und vorzugsweise ein Sauerstoffatom.

Beispiele für das sekundäre Phosphinderivat beinhalten
1,3-Cyclopentylenphosphinoxid, 1,4-Cyclooktylenphosphinoxid,
1,5-Cyclooktylenphosphinoxid und 1,5-Cyclooktylenphosphinsulfid. Bei der vorliegenden Erfindung sind 1,4-Cyclooktylenphosphinoxid und
1,5-Cyclooktylenphosphinoxid besonders bevorzugt.

Bei der vorliegenden Erfindung können die obigen Verbindungen allein oder in Kombination verwendet werden.

Das sekundäre Phosphinderivat kann mit einem bekannten Verfahren hergestellt werden. Ein Beispiel für Cycloalkylenphosphinoxide, die einen Ring haben, der aus einem Phosphoratom und der durch R¹ oder R² dargestellten Gruppe besteht, kann gemäß der folgenden Prozedur hergestellt werden: einem durch Formel (7) dargestellten Phosphin wird es ermöglicht, mit 1,5-Cyclooktadien, das durch Formel (8) dargestellt wird, in Gegenwart eines radikalischen Katalysators zu reagieren, wodurch eine Mischung von 1,4-Cyclooktylenphosphin, das durch Formel (9) dargestellt wird, und 1,5-Cyclooktylenphosphin, das durch Formel (10) dargestellt wird, erhalten wird. Die erhaltene Mischung wird dann oxidiert, wodurch eine Mischung von 1,4-Cyclooktylenephosphinoxid und 1,5-Cyclooktylenphosphinoxid hergestellt wird. Die Reaktion von Phosphin mit 1,5-Cyclooktadien ist in der ungeprüften Japanischen Patentanmeldung mit der Offenlegungsnummer 55-122790 offenbart und wird wie folgt ausgedrückt:

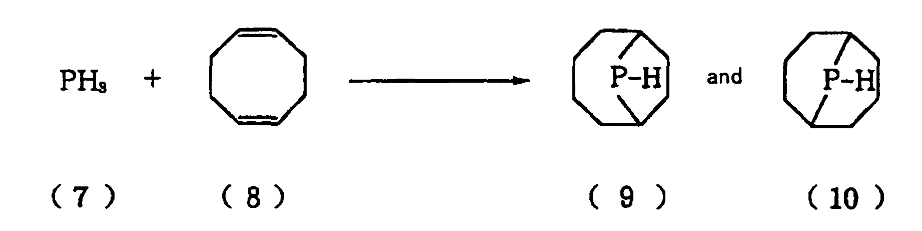

Das Phosphor enthaltende Epoxyharz der vorliegenden Erfindung hat eine strukturelle Einheit, die sich von dem sekundären Phosphinderivat wie oben beschrieben unterscheidet. Die strukturelle Einheit ist als ein reaktiver Rest definiert, der sich von dem sekundären Phosphinderivat ableitet. Der reaktive Rest wird chemisch an eine Epoxygruppe einer Epoxy- oder Polyepoxyverbindung gebunden, indem es der Epoxygruppe ermöglicht wird, mit aktivem Wasserstoff zu reagieren, der direkt an den Phosphor gebunden ist, der im sekundären Phosphinderivat enthalten ist.

Im reaktiven Rest ist Phosphor direkt an die Alkylengruppe, Cycloalkylengruppe oder Arylengruppe gebunden, die durch R¹ oder R² dargestellt ist, um die kovalente P-C - Bindung zu bilden. Daher verschlechtert der reaktive Rest nicht die elektrischen Eigenschaften der Vorrichtungen, im Gegensatz zu anderen organischen Phosphorverbindungen, welche die P-O- Bindung haben und daher zersetzt werden, um Phosphorsäure zu produzieren, die ausgewaschen wird. Weiterhin stellt der reaktive Rest überlegene Vorteile bereit wie z. B. chemische Beständigkeit.

Bei der vorliegenden Erfindung beträgt der Gehalt an Phosphor im Phosphor enthaltenden Epoxyharz 0.1 Gew.-% bis 10 Gew.-% und vorzugsweise 2 Gew.-% bis 8 Gew.-%, um eine hohe Flammwidrigkeit zu erzielen. Wenn der Phosphorgehalt weniger als 0.1 Gew.-% beträgt, ist die Flammwidrigkeit ungenügend. Im Gegensatz hierzu ist das Harz bezüglich Eigenschaften wie Hitzebeständigkeit und Feuchtigkeitsbeständigkeit unterlegen, wenn der Phosphorgehalt mehr als 10 Gew.-% beträgt, weil das gehärtete Harz eine niedrige Vernetzungsdichte aufweist.

Die strukturelle Einheit kann dadurch gebildet werden, dass es einer Epoxy- oder Polyepoxyverbindung ermöglicht wird, mit mindestens einem sekundären Phosphinderivat zu reagieren, das aus dem durch Formel (1) dargestellten sekundären Phosphinderivat und dem durch Formel (2) dargestellten sekundären Phosphinderivat ausgewählt ist.

Die Epoxy- oder Polyepoxyverbindung ist ein Monomer, Oligomer, oder Polymer, das mindestens zwei Epoxygruppen aufweist. Beispiele für die Epoxy- oder Polyepoxyverbindung beinhalten ein Bisphenol-A-Epoxyharz, ein Bisphenol-F-Epoxyharz, ein Bisphenol-S-Epoxyharz,ein Phenol-Novolak-Epoxyharz, ein Kresol-Novolak-Epoxyharz, ein Naphthalinepoxyharz, ein Biphenylepoxyharz und N-Glycidylverbindungen wie z. B. N,N'-Diglycidylanilin, Triglycidylisocyanurat und N,N,N',N'-Tetraglycidyl-bis(p-aminophenyl)-methan. Die N-Glycidylverbindungen werden durch die Reaktion von aromatischem Amin mit heterocyclischer Stickstoffbase erhalten. Die Epoxy- oder Polyepoxyverbindung ist nicht auf diese Verbindungen und Harze beschränkt. Die Verbindungen und Harze können allein oder als Kombination verwendet werden.

Die hierin verwendete Epoxy- oder Polyepoxyverbindung kann gesättigt oder ungesättigt sein und kann aliphatisch, cycloaliphatisch, aromatisch oder heterocyclisch sein. Die Epoxy- oder Polyepoxyverbindung kann einen Substituenten wie z. B. eine Alkylgruppe, Arylgruppe oder Ethergruppe aufweisen, der keine Nebenreaktion verursacht, die mit der Hauptreaktion oder Mischoperation interferiert. Eine Mischung von verschiedenen Epoxy- oder Polyepoxyverbindungen kann verwendet werden. Die Epoxy- oder Polyepoxyverbindung kann ein zahlenmittleres Molekulargewicht Mn von ungefähr 9000 oder weniger und im Allgemeinen ungefähr von 150 bis 4000 aufweisen.

Die Epoxy- oder Polyepoxyverbindung ist Polyglycidylether oder Polyglycidylester, der sich von einem mehrwertigen Alkohol oder Phenol ableitet, und sich vorzugsweise von einem zweiwertigen Alkohol, einem zweiwertigen Phenol, einer Verbindung, die durch Hydrierung eines solchen zweiwertigen Phenols erhalten wird, oder einem Novolakharz ableitet. Das Novolakharz wird dadurch hergestellt, dass man ein einwertiges oder mehrwertiges Phenol mit Aldehyd reagieren lässt. Der einwertige oder mehrwertige Phenol ist vorzugsweise Phenol oder Kresol und der Aldehyd ist vorzugsweise Formaldehyd. Die Epoxy- oder Polyepoxyverbindung kann mit einer bekannten Methode hergestellt und erhalten werden, indem man beispielsweise Polyol mit Epichlorhydrin reagieren läßt.

Bevorzugte Beispiele für das zweiwertige Phenol beinhalten Resorcinol, Hydrochinon, 2,2'-Bis(4-hydroxyphenyl)propan (im Allgemeinen als Bisphenol-A bezeichnet), eine Mischung von Dihydroxydiphenylmethanisomeren (im Allgemeinen als Bisphenol-F-Isomere bezeichnet), 4,4'-Dihydroxydiphenylcyclohexan, 4,4'-Dihydroxy-3,3'-dimethyldiphenylpropan, 4,4'-Dihydroxybiphenyl, 4,4'-Dihydroxydibenzophenon, 1,1'-Bis(4-hydroxyphenyl)ethan, 1,1'-Bis(4-hydroxyphenyl)isobutan, 2,2'-Bis(4-hydroxy-tert-butylphenyl)propan, Bis(2-hydroxynaphthyl)methan, 1,5-Dihydroxynaphthalin, Tris(4-hydroxyphenyl)methan und 1,1'-Bis(4-hydroxyphenyl)ether. Bei der vorliegenden Erfindung werden bevorzugt Bisphenol-A und Bisphenol-F benutzt.

Bevorzugte Beispiele für die Polyepoxyverbindung beinhalten außerdem Polyglycidylether eines mehrere Hydroxygruppen enthaltenden aliphatischen Alkohols. Beispiele für einen solchen mehrwertigen Alkohol beinhalten 1,4-Butandiol, 1,6-Hexandiol, Polyalkylenglykol, Glycerol, Trimethylolpropan, Neopentylglykol, 2,2'-Bis(4-hydroxycyclohexyl)propan und Pentaerythrol.

Bevorzugte Beispiele für die Polyepoxyverbindung beinhalten außerdem Polyglycidylester, die erhalten werden können, indem man Epichlorhydrin oder eine ähnliche Epoxyverbindung mit einer aliphatischen, cycloaliphatischen oder aromatischen Polycarbonsäure wie z.B. Oxalsäure, Adipinsäure, Glutarsäure, Phthalsäure, Isophthalsäure, Terephthalsäure, Tetrahydrophthalsäure, Hexahydrophthalsäure, 2,6-Naphthalindicarbonsäure oder einem aliphatischen Säuredimer reagieren läßt. Beispiele für Polyglycidylester beinhalten Diglycidylterephthalat und Diglycidylhexahydrophthalat.

In einigen Fällen kann vorteilhaft eine polymerisierbare olefinisch ungesättigte Verbindung verwendet werden, die eine Epoxygruppe hat. Eine solche Verbindung kann dadurch erhalten werden, dass man den Glycidylester von Acrylsäure oder Methacrylsäure mit Vinylacetat oder Styrol in einem Emulsionspolymerisationsverfahren miteinander reagieren lässt.

Beispiele für die Epoxy- oder Polyepoxyverbindung beinhalten außerdem heterocyclische Verbindungen wie z.B. ein Hydantoinepoxyharz, Triglycidylisocyanurat, ein Oligomer von Triglycidylisocyanurat, Triglycidyl-p-aminophenol, Triglycidyl-p-aminodiphenylether, Tetraglycidyldiaminodiphenylmethan, Tetraglycidyldiaminodiphenylether, Tetrakis(4-glycidyloxyphenyl)ethan, Urazolepoxid, Uracilepoxid und ein Oxazolidinon-modifiziertes Epoxyharz.

Beispiele für die Epoxy- oder Polyepoxyverbindung beinhalten weiterhin Verbindungen, die sich von aromatischen Aminen wie z.B. Anilin ableiten. Beispiele solcher Verbindungen beinhalten N,N'-Diglycidylanilin, Diaminodiphenylmethan, N,N'-Dimethylaminodiphenylmethan und N,N'-Dimethylaminodiphenylsulfon.

Andere bevorzugte Beispiele für die Epoxy- oder Polyepoxyverbindung sind offenbart in Henry Lee und Kris Neville, Handbook of Epoxy Resins, McGraw-Hill Book Company, 1967; Henry Lee, Epoxy Resins, American Chemical Society, 1970; Wagner/Sarx, Lackkunstharze, Carl Hanser Verlag, 1971, 5. Auflage, Seite 174 ff.; Angew. Makromol. Chemie, Band 44, 1975, Seiten 151-163; der DE-A-2757733 und der EP-A-0384939.

Weiterhin beinhalten bevorzugte Beispiele für die Epoxy- oder Polyepoxyverbindung Bisglycidylether, die sich von Bisphenol-A, Bisphenol-F oder Bisphenol-F ableiten, d.h. ein Produkt der Reaktion eines dieser Bisphenole mit Epihalohydrin, zum Beispiel Epichlorhydrin; ein Oligomer eines solchen Ethers; Polyglycidylether eines Phenol-Formaldehyd- und/oder Kresol-Formaldehyd-Novolak-Harzes; Diglycidylester von Phthalsäure, Isophthalsäure, Terephthalsäure, Tetrahydrophthalsäure, Hexahydrophthalsäure oder Trimellithsäure; eine N-Glycidylverbindung eines aromatischen Amins oder einer heterocyclischen Stickstoffbase; und eine Diglycidyl- oder Polyglycidylverbindung eines aliphatischen, mehrere Hydroxylgruppen enthaltenden Alkohols wie z.B. 1,4-Butandiol, Trimethylolpropan oder Polyalkylenglykol. Beispiele der N-Glycidylverbindung beinhalten N,N'-Diglycidylanilin, N,N,O-Triglycidyl-p-aminophenol, Triglycidylisocyanurat, N,N,N',N'-Tetraglycidyl-bis(p-aminophenyl)methan, ein Hydantoin-Epoxyharz und ein Arachinsäure-Epoxyharz.

Bevorzugte Beispiele für die Epoxy- oder Polyepoxyverbindung beinhalten weiterhin Oxazolidinon-modifizierte Epoxyharze, die in Angew. Makromol. Chemie, Band 44, 1975, Seiten 151-163 offenbart sind. Ein bevorzugtes Beispiel für derartige Harze ist ein Produkt, das dadurch erhalten wird, dass man Bisphenol-A-Diglycidylether mit Diphenylmethandiisocyanat in der Gegenwart eines geeigneten Promotors reagieren läßt.

Die Menge des sekundären Phosphinderivates beträgt vorzugsweise 0.51 bis 104.3 Gewichtsteile, bezogen auf 100 Gewichtsteile der Epoxy- oder Polyepoxyverbindung, wenn das Derivat 1,4-Cyclooktylenphosphinoxid ist. Gemäß dem obigen Mischungsverhältnis beträgt der Gehalt an Phosphor im erhaltenen Phosphor enthaltenden Epoxyharz 0.1 Gew.-% bis 10 Gew.-%.

Die Reaktionstemperatur beträgt im Allgemeinen -10 °C bis 200 °C und vorzugsweise 70 °C bis 150 °C.

Die Reaktion kann erforderlichenfalls in Gegenwart eines Katalysators durchgeführt werden. Beispiele für den Katalysator beinhalten tertiäre Amine wie z.B. Benzylmethylamin; Ammoniumsalze wie z.B. Tetramethylammoniumchlorid; Phosphine wie z.B. Triphenylphosphin und Tris(2,6-dimethoxyphenyl)phosphin; Phosphoniumsalze wie z.B. Ethyltriphenylphosphoniumbromid; und Imidazole wie z.B. 2-Methylimidazol und 2-Ethyl-4-Methylimidazol. Diese Verbindungen können allein oder als Kombination verwendet werden.

Bei der Reaktion kann je nach Erfordernis ein Lösungsmittel verwendet werden. Beispiele für das Lösungsmittel beinhalten aliphatische Kohlenwasserstoffe wie z.B. Hexan; aromatische Kohlenwasserstoffe wie z.B. Benzol, Toluol und Xylol; Nitrile wie z.B. Acetonitril und Propionitril; aromatische Kohlenwasserstoffhalogenide wie z.B. Chlorbenzol; Haloalkane wie z.B. Methylenchlorid und Chloroform; Tetrahydrofuran; Dioxan; Dialkylether und Glykolether. Diese Verbindungen können allein oder als Kombination verwendet werden.

Das wie oben beschrieben erhaltene Phosphor enthaltende Epoxyharz hat im Allgemeinen ein Epoxyäquivalent von 100 bis 1000 g / Äquivalent und vorzugsweise von 200 bis 500 g / Äquivalent. Das Phosphor enthaltende Epoxyharz hat im Allgemeinen einen Phosphorgehalt von 0.1 Gew.-% bis 10 Gew.-% und vorzugsweise von 2 Gew.-% bis 8 Gew.-%.

Das Phosphor enthaltende Epoxyharz kann durch Kettenpolymerisation unter Verwendung eines Polymerisationsinitiators oder durch eine sukzessive Polymerization unter Verwendung eines Härtungsmittels hergestellt werden. Das gehärtete, Phosphor enthaltende Epoxyharz hat eine hohe Flammwidrigkeit.

Eine Phosphor enthaltende Epoxyharz-Zusammensetzung der vorliegenden Erfindung enthält das Phosphor enthaltende Epoxyharz und das Härtungsmittel oder den Polymerisationsinitiator.

Der Polymerisationsinitiator ist nicht besonders beschränkt und jeder Polymerisationsinitiator, der das Phosphor enthaltende Epoxyharz polymerisieren kann, kann verwendet werden. Beispiele für den Polymerisationsinitiator beinhalten Initiatoren für die kationische Polymerisation wie z.B. Methansulfonsäure, Aluminumchlorid, Zinnchlorid, ein Bortrifluorid-Ethylamin-Komplex und Bortrifluoridetherat; Initiatoren für die radikalische Polymerisation wie z.B. Benzoylperoxid und Azobisisobutyronitril; und Initiatoren für die anionische Polymerization wie Kaliummethylat, Triethylamin und 2-Dimethylaminophenol. Diese Verbindungen können allein oder in Kombination verwendet werden.

Das Härtungsmittel ist nicht besonders begrenzt und jedes Härtungsmittel, das dem Fachmann auf diesem Gebiet bekannt ist, kann verwendet werden. Beispiele für das Härtungsmittel beinhalten lineare aliphatische Diamine wie z.B. Ethylendiamin, Trimethylendiamin, Tetramethylendiamin, Hexamethylendiamin, die zwei bis 20 Kohlenstoffatome enthalten; Amine wie z.B. m-Phenylendiamin, p-Phenylendiamin, p-Xylylendiamin, 4,4'-Diaminodiphenylmethan, 4,4'-Diaminodiphenylpropan, 4,4'-Diaminodiphenylether, 4,4'-Diaminodiphenylsulfon, 4,4'-Diaminodicyclohexan, Bis(4-aminophenyl)phenylmethan, 1,5-Diaminonaphthalin, m-Xylylendiamin, p-Xylylendiamin, 1,1- Bis(4-aminophenyl)cyclohexan und Dicyandiamid; Phenolnovolakharze wie z.B. Kresolnovolakharz, ein tert.-Butylphenolnovolakharz, ein Nonylphenolnovolakharz und ein Triazin-modifiziertes Novolakharz; Phenolresolharze; Poly(oxystyrole) wie z.B. Poly(p-oxystyrol); Phenolharze, die durch Copolymerisation einer Carbonylverbindung und einer Phenolverbindung erhalten wurden, wie z.B. ein Phenolaralkylharz oder ein Naphtholaralkylharz, das einen aromatischen Ring hat, wie z.B. einen Benzolring oder einen Naphthalinring, bei dem Wasserstoff durch eine Hydroxygruppe substituiert ist; und Säureanhydride wie z.B. Pyromellithsäuredianhydrid, Trimellithsäureanhydrid und Maleinsäureanhydrid. Diese Verbindungen können allein oder in Kombination verwendet werden.

Die Menge des Polymerisationsinitiators beträgt im Allgemeinen 0.1 Mol-% bis 10 Mol-%, bezogen auf das Phosphor enthaltende Epoxyharz und vorzugsweise 0.5 Mol-% bis 2 Mol-%. Die Menge des Polymerisationsinitiators wird vorzugsweise in Abhängigkeit vom Epoxyäquivalent des Harzes bestimmt.

Bei der Polymerisationsreaktion, die das Härtungsmittel verwendet, kann je nach Erfordernis ein Katalysator verwendet werden.

Beispiele für den Katalysator beinhalten tertiäre Aminoverbindungen wie z.B. 1,8-Diaza-bicyclo(5,4,0)undecen-7, Triethylenediamin und Benzyldimethylamin; Imidazolverbindungen wie z.B. 2-Methylimidazol, 2-Ethyl-4-methylimidazol, 2-phenylimidazol und 2-Phenyl-4-methylimidazol; organische Phosphinverbindungen wie z.B. Triphenylphosphin und Tributylphosphin; Phosphoniumsalze und Ammoniumsalze. Diese Verbindungen können allein oder als Kombination verwendet werden.

Bei der Polymerisationsreaktion kann eine zusätzliche Epoxy- oder Polyepoxyverbindung in Kombination mit der oben beschriebenen Epoxy- oder Polyepoxyverbindung verwendet werden. Die zusätzliche Epoxy- oder Polyepoxyverbindung ist ein Monomer, Oligomer oder Polymer, die jeweils mindestens zwei Epoxygruppen haben. Beispiele für die zusätzlichen Epoxy- oder Polyepoxyverbindungen sind die gleichen wie diejenigen der früheren Epoxy- oder Polyepoxyverbindung und beinhalten ein Bisphenol-A-Epoxyharz; ein Bisphenol-F-Epoxyharz; ein Bisphenol-S-Epoxyharz; ein Phenol-Novolak-Epoxyharz; ein Kresol-Novolak-Epoxyharz; ein Naphthalin-Epoxyharz; ein Biphenylepoxyharz; und N-Glycidylverbindungen wie z.B. N,N'-Diglycidylanilin, Triglycidylisocyanurat und N,N,N',N'-Tetraglycidyl-bis(p-aminophenyl)methan, die sich von einem aromatischen Amin und einer heterocyclischen Stickstoffbase ableiten. Die zusätzliche Epoxy- bzw. Polyepoxyverbindung ist nicht auf diese Harze und Verbindungen beschränkt, die alleine oder als Kombination verwendet werden können.

Das Mischungsverhältnis dieser Epoxy- oder Polyepoxyverbindungen ist nicht besonders beschränkt und diese Verbindungen können derart gemischt werden, dass der Phosphorgehalt in dem Phosphor enthaltenden Epoxyharz 0.1 Gew.-% bis 10 Gew.-% und vorzugsweise 2 Gew.-% bis 8 Gew.-% beträgt.

Die flammwidrige Phosphor enthaltende Epoxyharzzusammensetzung der vorliegenden Erfindung kann außerdem ein Flammschutzmittel, einen Härtungsbeschleuniger, einen anorganischen Füllstoff, ein Silankupplungsreagenz, ein Entformungsmittel, ein Färbungsmittel, ein "stress release agent" und ein oberflächenaktives Mittel enthalten.

Beispiele für das Flammschutzmittel beinhalten wasserhaltige Metalloxide, Phosphor-Flammschutzmittel und Stickstoff enthaltende Flammschutzmittel.

Die wasserhaltigen Metalloxide sind Verbindungen, die aufgrund einer endothermen Reaktion auslöschende Eigenschaften haben, oder Doppelsalze, die eine solche Verbindung enthalten.

Die Verbindungen werden durch die Formel MₘOₙ·xH₂O dargestellt, in der M ein Metall bedeutet, m und n jeweils eine ganze Zahl darstellen, die größer oder gleich 1 ist und in Abhängigkeit von der Valenz des Metalls bestimmt ist, und x die Anzahl der Mole an Kristallwasser darstellt. Beispiele für die wasserhaltigen Metalloxide beinhalten Aluminiumhydroxid, Magnesiumhydroxid, basisches Magnesiumcarbonat, Calciumhydroxid, Bariumhydroxid, Zirkonhydroxid, Dawsonit, Zinkstannat, Zinkborat, Aluminiumborat, Antimonpentoxid, basisches Zinkcarbonat, Kobaltoxid, Zirkonoxid, Zinnoxid, Aluminiumoxid, Titanoxid, Magnesiumoxid, Calciumsilikat, Borax, Zinkmolybdat, Zinkphosphat, Magnesiumphosphat, Hydrotalcit, Hydrocalumit, Kaolin, Talk, Sericit, Pyrophillit, Bentonit, Kaolinit, Calciumsulfat und Zinksulfat.

Beispiele für Stickstoff enthaltende Flammschutzmittel beinhalten Melaminderivate wie z. B. Melamin, Melamincyanurat, methyliertes Melamin, Melam, Melem, Melon, Succinoguanamin, Melaminsulfat, Acetoguanaminsulfat, Melamsulfat, Guanylmelaminsulfat, ein Melaminharz, ein BT-Harz, Cyanursäure, Isocyanursäure, ein Isocyanursäurederivat, Melaminisocyanurat, Benzoguanamin und Acetoguanamin; und Guanidinverbindungen. Eine Reaktionsmischung, die durch die Kondensation einer Triazinverbindung, einer Phenolverbindung und einem Aldehyd erhalten wurde, kann für die Stickstoff enthaltenden Flammschutzmittel verwendet werden.

Beispiele für die Phosphor-Flammschutzmittel beinhalten Triethylphosphat, Trikresylphosphat, Triphenylphosphat, Kresyl-Phenyl-Phosphat, Oktyldiphenylphosphat, Ethyldiethylenphosphat, Butylbis(hydroxypropylen)phosphat, Dinatriumethylphosphat?, Methylphosphonsäure, Dimethylmethylphosphonat, Diethylmethylphosphonat, Ethylphosphonsäure, Propylphosphonsäure, Butylphosphonsäure, 2-Methyl-propylphosphonsäure, t-Butylphosphonsäure, 2,3-Dimethylbutylphosphonsäure, Oktylphosphonsäure, Phenylphosphonsäure, Dioktylphenylphosphonat, Dimethylphosphinsäure, Methylethylphosphinsäure, Methylpropylphosphinsäure, Diethylphosphinsäure, Dioktylphosphinsäure, Phenylphosphinsäure, Ethylphenylphosphinsäure, Diphenylphosphinsäure, Bis(4-methoxyphenyl)phosphinsäure, roter Phosphor, Ammoniumphosphat, Ammoniumpolyphosphat, Melaminphosphat, Guanylharnstoffphosphat, Melaminepolyphosphat, Guanidinphosphat, Ethylendiaminphosphonat, Phosphazen und Melaminmethylphosphonat.

Die obigen, als Flammschutzmittel wirkenden Verbindungen können alleine oder als Kombination verwendet werden. Derivate der Verbindungen können ebenfalls verwendet werden.

Beispiele für den anorganischen Füllstoff beinhalten Quarzglaspulver, Pulver von kristallinem Siliziumdioxid, Alumina, Siliziumnitrid, Aluminumnitrid, Bornitrid, Magnesia, Titanoxid, Calciumcarbonat, Magnesiumcarbonat, Talk, Calciumsilikat, Glasfasern, Asbest, Bariumsulfat und feines Pulver von E-Glas. Diese Materialien können allein oder als Kombination benutzt werden. Beispiele für den härtenden Beschleuniger beinhalten tertiäre Aminoverbindungen wie z. B. 1,8-Diazabicyclo(5,4,0)undecen-7, Triethylendiamin und Benzyldimethylamin; Imidazolverbindungen wie z.B. 2-Methylimidazol, 2-Ethyl-4-methylimidazol, 2-Phenylimidazol und 2-Phenyl-4-methylimidazol; organische Phosphinverbindungen wie z. B. Triphenylphosphin und Tributylphosphin; Phosphoniumsalze und Ammoniumsalze. Diese Verbindungen können alleine oder in Kombination eingesetzt werden.

Beispiele für das Silan-Kupplungsagens beinhalten Epoxysilane wie z.B. γ-Glycidoxypropyltrimethoxysilan und Aminosilane wie z.B. N-Phenyl-γ-Aminopropyltrimethoxysilan.

Beispiele für das Entformungsmittel beinhalten aliphatische Säuren wie z.B. Stearinsäure, Montanylsäure, Palmitinsäure, Ölsäure und Linolsäure; Salze von solchen aliphatischen Säuren, die Calcium, Magnesium, Aluminium oder Zink enthalten; Amide der aliphatischen Säuren; Phosphorsäureester; Polyethylen; Bisamid; Polyolefine mit einer Carboxylgruppe; und natürliches Carnaubawachs. Diese Materialien können allein oder als Kombination verwendet werden.

Beispiele für das Färbungsmittel beinhalten Kohleschwarz und Titanoxid.

Beispiele für das "stress release agent" beinhalten Silicongel, Silicongummi und Siliconöl.

Beispiele für das oberflächenaktive Mittel beinhalten Ester von Polyethylenglykol und aliphatischen Säuren, Ester von Sorbitan und aliphatischen Säuren und Monoglyceride von aliphatischen Säuren.

Die flammwidrige, Phosphor enthaltende Epoxyharz-Zusammensetzung der vorliegenden Erfindung ist ein sicheres Plastikmaterial. Daher kann die Zusammensetzung für Dichtungsmittel, Formverbindungen ("molding compounds"), Abformverbindungen ("casting compounds"), Klebstoffe und elektrisch isolierende Farbe für elektrische Komponenten verwendet werden und kann auch für mit Kupfer plattierte Laminate verwendet werden, die in gedruckten Schaltkreisen ("printed wiring boards") oder elektrischen Schaltplatinen ("electric circuit boards") enthalten sind.

Die Phosphor enthaltende Epoxyharz-Zusammensetzung enthält das Phosphor enthaltende Epoxyharz and das Härtungsmittel oder den Polymerisationsinitiator und wird in einem ungehärteten, halb gehärteten oder gehärteten Zustand verwendet. Die Zusammensetzung kann zu Tabletten, Filmen, halb gehärteten Körpern, gehärteten Körpern, Schmelzen, Klarlacken oder Lösungen verarbeitet werden.

Wenn die Phosphor enthaltende Epoxyharz-Zusammensetzung als ein Dichtungsmaterial verwendet wird, befindet sich die Zusammensetzung vorzugsweise in einem gleichförmig gemischten oder gekneteten Zustand. Das Dichtungsmaterial wird gemäß folgendem Verfahren hergestellt: die Zusammensetzung wird bei erhöhter Temperatur mit beispielsweise einem Roller, Kneter oder Mischer geknetet und die resultierende Zusammensetzung wird gekühlt, gebrochen und dann zu Tabletten geformt.

Halbleitervorrichtungen, die eine hohe Flammwidrigkeit, einen hohen Feuchtigkeitswiderstand und elektrische Verlässlichkeit aufweisen, können durch die Abdichtung von Halbleiterelementen und/oder Anschlussrahmen ("lead frames") in einem Transferformverfahren ("transfer molding process") unter Verwendung des oben beschriebenen Dichtungsmaterials hergestellt werden. Das Formungsverfahren ist nicht besonders beschränkt, außer hinsichtlich der Verwendung des Dichtungsmaterials, und ein gewöhnliches Verfahren kann verwendet werden.

Die Phosphor enthaltende Epoxyharz-Zusammensetzung kann in ein Harzklarlack geformt werden, indem die Zusammensetzung in einem Lösungsmittel aufgelöst wird. Das verwendete Lösungsmittel ist vorzugsweise aprotisch. Beispiele für das Lösungsmittel beinhalten N,N'-Dimethylformamid; Ether wie z. B. Diethylether, Tetrahydrofuran, Dioxan, Ether, die dadurch erhalten wurden, dass man Ethylglykol mit einem Monoalkohol reagieren ließ, der eine lineare oder verzweigte Alkylgruppe mit einem bis sechs Kohlenstoffatomen hat, Propylenglykolether und Butylglykolether; Ketone wie z. B. Aceton, Methylethylketon, Methylisopropylketon, Methylisobutylketon und Cyclohexanon; Ester, Ethylacetat, Butylacetat, Ethylenglykolacetat und Methoxypropylacetat; Methoxypropanol; Kohlenwasserstoffhalogenide und cycloaliphatische oder aromatische Kohlenwasserstoffe. Unter diesen Verbindungen sind N,N'-Dimethylformamid, Methylethylketon, Toluol und Xylol bevorzugt. Diese Verbindungen können allein oder als Kombination verwendet werden.

Bei der vorliegenden Erfindung kann das bei der Polymerisationsreaktion verwendete Lösungsmittel in der Reaktionsmischung verbleiben, wodurch ein Harzklarlack hergestellt werden kann. Der erhaltene Harzklarlack kann zur Herstellung von Prepregs verwendet werden. Das Herstellungsverfahren ist wie folgt: der Harzklarlack ("resin varnish") wird auf den Basismaterialien wie z.B. Papierblättern, Glas-Gewebe-Tüchern ("glass fabric sheets"), Glas-Vliesstoff-Tüchern oder Textilientüchern, die eine von Glas verschiedene Komponente enthalten, aufgetragen, wodurch die Basismaterialien mit dem Klarlack imprägniert werden. Die resultierenden Basismaterialien werden bei 80 °C bis 200 °C in einem Trocknungsofen getrocknet. Eine vorbestimmte Anzahl der erhaltenen Prepregs wird gestapelt, erhitzt und dann gepresst, wodurch ein Laminat hergestellt wird. Auf die gleiche Weise wie oben kann ein mit Metall plattiertes Laminat für gedruckte Schaltungen hergestellt werden. Außerdem kann der Klarlack für einen isolierenden Zwischenschicht-Klebstoff zur Verbindung von mehrschichtigen gedruckten Schaltplatinen miteinander verwendet werden. Bei einer solchen Anwendung wird der Klarlack auf eine Ankerfläche ("anchor face") eines dünnen Kupferfilms aufgebracht und der resultierende Film dann bei 80 °C bis 130 °C getrocknet, so dass das Lösungsmittel nicht im Klarlack ("varnish") bleibt.

Die Phosphor enthaltende Epoxyharz-Zusammensetzung der vorliegenden Erfindung kann mit einer gewöhnlichen Komponente wie einem Härter oder Gummi gemischt werden, wodurch ein flammwidriges Klebstoffmittel oder ein flammwidriger Klebstoff-Film hergestellt wird.

### Beispiele

Die vorliegende Erfindung wird nun im Detail mit Beispielen beschrieben. Jedoch ist die vorliegende Erfindung nicht auf diese Beispiele begrenzt.

### Herstellungsbeispiel 1

In einen Reaktor wurden 1843 g (16.69 Mol) 1,5-Cyclooktadien, hergestellt von Tokyo Kasei Kogyo Co., Ltd., und 3750 ml Toluol gegeben und die Atmosphäre im resultierenden Reaktor wurde vollständig mit Stickstoff ersetzt. In den resultierenden Reaktor wurden 731 g (21.50 Mol) Phosphin, hergestellt von Nippon Chemical Industrial Co., Ltd., gegeben und der resultierende Reaktor wurde auf 60 °C erhitzt. In den resultierenden Reaktor wurden unter Druck 58.8 g (0.237 mol) 2,2-Azobis-(2,4-dimethylvaleronitril), hergestellt von Japan Hydrazine Company Inc., das als ein Radikalinitiator fungiert, eingespeist, nachdem drei Stunden vergangen waren. Die Mischung wurde auf 60 °C gehalten und über Nacht stehen gelassen, wodurch eine Toluollösung erhalten wurde, die eine Mischung von 1,4-Cyclooktylenphosphin und 1,5-Cyclooktylenphosphin enthielt. Die Lösung wurde mittels Gaschromatographie analysiert. Die Analyse ergab, dass der Gehalt an Mischung in der Lösung 31.9 Gew.-% betrug und das Verhältnis von 1,4-Cyclooktylenphosphin zu 1,5-Cyclooktylenphosphin 38.4 zu 61.6. Das Isomerenverhältnis wurde anhand des Flächenverhältnisses der Isomeren bestimmt.

Ein 2000-ml Vierhalskolben, der mit einem Rührer, einem Kühler und einem Tropftrichter ausgestattet war, wurde vorbereitet und die Atmosphäre im Kolben wurde vollständig mit Stickstoff ersetzt. In den Kolben wurden bei Raumtemperatur 434.6 g (0.975 Mol) der durch die obige Reaktion erhaltenen Lösung gegeben. Weiterhin wurden 440 g Methanol in den resultierenden Kolben gegeben, der dann in einem Eisbad auf ungefähr 5 °C gekühlt wurde. In den resultierenden Kolben wurden 106.5 g (1.05 Mol) wässriges Wasserstoffperoxid durch den Tropftrichter getropft, nachdem drei Stunden vergangen waren. Die Beendigung der Reaktion wurde mit einer Gaschromatographiemethode bestimmt. Nachdem die Oxidationsreaktion beendet war, wurde die Reaktionsmischung unter Verwendung eines Rotationsverdampfers konzentriert. Hierdurch wurden 152.8 g (0.996 Mol) einer farblosen und kristallinen Mischung von 1,4-Cyclooktylenphosphinoxid und 1,5-Cyclooktylenphosphinoxid erhalten. Die Mischung wurde mittels NMR analysiert. Die Analyse ergab, dass das Verhältnis von 1,4-Cyclooktylenphosphinoxid zu 1,5-Cyclooktylenphosphinoxid 39.4 zu 60.6 betrug. Das Isomerenverhältnis wurde anhand des Flächenverhältnisses der Isomere bestimmt.

### Ausführungsbeispiel 1

In einen Reaktor wurden 120.0 g eines o-Kresol-Novolak-Epoxyharzes (Epototo YDCN-701, hergestellt von Tohto Kasei Co., Ltd., mit einem Epoxyäquivalent von 200.2 g / Äquivalent) gegeben. Der Reaktor wurde anschließend auf 120 °C erhitzt. In den erhaltenen Reaktor wurden 22.72 g der in Beispiel 1 hergestellten Mischung gegeben, die 1,4-Cyclooktylenphosphinoxid und 1,5-Cyclooktylenphosphinoxid enthielt. Anschließend wurden 0.047 g Triphenylphosphin zugegeben, das als ein Katalysator fungiert, während die Mischung in dem Reaktor gerührt wurde. Der Reaktor wurde dann auf 150 °C erhitzt. Nach 30 Minuten war im Reaktor eine durchsichtige Schmelze hergestellt. Das Umrühren wurde für weitere acht Stunden fortgesetzt und der Reaktor wurde dann gekühlt, wodurch ein weißer Feststoff erhalten wurde. Der Feststoff wurde in einem Mörser zerstampft, wodurch 141.8 g weißes Pulver erhalten wurden. Das weiße Pulver war ein Phosphor enthaltendes Epoxyharz (im Folgenden als Harz A bezeichnet), das ein Epoxyäquivalent von 311.2 g / Äquivalent und einen Phosphorgehalt von 3.1 Gew.-% hatte.

Auf die gleiche Weise wie oben wurde auch das in den anderen Beispielen verwendete Harz A hergestellt.
³¹P NMR (121.5 MHz, CDCl₃): σ 46.62 (S), 73.13 (S)
IR (KBr, cm⁻¹): 3214 (OH - Gruppe), 3048 (Aromatische C-H - Bindung), 2915 (C-H - Bindung), 1212 (Aromatische C-O-C - Bindung)

### Ausführungsbeispiel 2

In einen Reaktor wurden 30.45 g eines Phenol-Novolak-Epoxyharzes (Epototo YDPN-638, hergestellt von Tohto Kasei Co., Ltd., mit einem Epoxyäquivalent von 178.2 g / Äquivalent) gegeben. Der Reaktor wurde dann auf 80 °C erhitzt. In den resultierenden Reaktor wurden 6.08 g der im Herstellungsbeispiel 1 hergestellten Mischung gegeben, die 1,4-Cyclooktylenphosphinoxid und 1,5-Cyclooktylenphosphinoxid enthielt. Anschließend wurden 0.024 g Triphenylphosphin, das als ein Katalysator fungiert, in den Reaktor gegeben, während die Mischung im Reaktor gerührt wurde. Der Reaktor wurde dann auf 150 °C erhitzt. Nach 30 Minuten war im Reaktor eine durchsichtige Schmelze hergestellt. Das Rühren wurde für weitere acht Stunden fortgesetzt und der Reaktor dann gekühlt, wodurch ein weißer Feststoff erhalten wurde. Der Feststoff wurde in einem Mörser zerstampft, wodurch 35.7 g weißes Pulver erhalten wurde. Das weiße Pulver war ein Phosphor enthaltendes Epoxyharz (im Folgenden als Harz B bezeichnet), das ein Epoxyäquivalent von 281.6 g / Äquivalent und einen Phosphorgehalt von 3.2 Gew.-% hatte.

Auf die gleiche Weise wie oben wurde auch das in weiteren Beispielen verwendete Harz B hergestellt.
31P NMR (121.5 MHz, CDCl₃): σ 46.87 (S), 73.35 (S)
IR (KBr, cm⁻¹): 3261 (OH - Gruppe), 3058 (Aromatische C-H - Bindung), 2920 (C-H - Bindung), 1240 (Aromatische C-O-C - Bindung)

### Ausführungsbeispiel 3

In einen Reaktor wurden 40.02 g eines o-Kresol-Novolak-Epoxyharzes (Epototo YDCN-701, hergestellt von Tohto Kasei Co., Ltd., mit einem Epoxyäquivalent von 200.2 g / Äquivalent) und 25.80 g eines Bisphenol-A - Epoxyharzes (Epototo YD-128, hergestellt von Tohto Kasei Co., Ltd., mit einem Epoxyäquivalent von 186.6 g / Äquivalent) gegeben. Der Reaktor wurde dann auf 120 °C erhitzt. In den resultierenden Reaktor wurden 11.42 g der in Herstellungsbeispiel 1 hergestellten Mischung gegeben, die 1,4-Cyclooktylenphosphinoxid und 1,5-Cyclooktylenphosphinoxid enthielt. Anschließend wurden 0.024 g Triphenylphosphin, das als Katalysator fungiert, in den Reaktor gegeben, während die Mischung im Reaktor umgerührt wurde. Der Reaktor wurde dann auf 150 °C erhitzt. Nach 30 Minuten war im Reaktor eine durchsichtige Schmelze hergestellt. Das Umrühren wurde für acht weitere Stunden fortgesetzt und der Reaktor wurde dann gekühlt, wodurch ein weißer Feststoff erhalten wurde. Der weiße Feststoff wurde in einem Mörser zerstoßen, wodurch 76.5 g weißes Pulver erhalten wurde. Das weiße Pulver war ein Phosphor enthaltendes Epoxyharz (im Folgenden als Harz C bezeichnet), das ein Epoxyäquivalent von 293.8 g / Äquivalent und einen Phosphorgehalt von 2.8 Gew.-% hatte.

Auf die gleiche Weise wurde auch das in den anderen Beispielen verwendete Harz C hergestellt.
³¹P NMR (121.5 MHz, CDCl₃): σ 46.91 (S), 73.50 (S)
IR (KBr, cm⁻¹): 3211 (OH - Gruppe), 3053 (Aromatische C-H - Bindung), 2921 (C-H - Bindung), 1250 (Aromatische C-O-C - Bindung)

### Ausführungsbeispiel 4

In einen Reaktor wurden 57.00 g eines Phenol-Novolak-Epoxyharzes (Epototo YDPN-638, hergestellt von Tohto Kasei Co., Ltd., mit einem Epoxyäquivalent von 178.2 g / Äquivalent) gegeben. Der Reaktor wurde dann auf 80 °C erhitzt. In den resultierenden Reaktor wurden 4.68 g der im Herstellungsbeispiel 1 hergestellten Mischung gegeben, die 1,4-Cyclooktylenphosphinoxid und 1,5-Cyclooktylenphosphinoxid enthielt. Anschließend wurden 0.024 g Triphenylphosphin, das als Katalysator fungiert, in den Reaktor gegeben, während die Mischung im Reaktor gerührt wurde. Der Reaktor wurde dann auf 150 °C erhitzt. Nach 30 Minuten war im Reaktor eine durchsichtige Schmelze hergestellt. Das Umrühren wurden für acht weitere Stunden fortgesetzt und der Reaktor dann gekühlt, wodurch ein weißer Feststoff erhalten wurde. Der Feststoff wurde in einem Mörser zerstoßen, wodurch 61.0 g weißes Pulver erhalten wurde. Das weiße Pulver war ein Phosphor enthaltendes Epoxyharz (im Folgenden als Harz D bezeichnet), das ein Epoxyäquivalent von 213.5 g / Äquivalent und einen Phosphorgehalt von 1.4 Gew.-% hatte.

Auf die gleiche Weise wie oben wurde auch das in den anderen Beispielen verwendete Harz D hergestellt.
³¹P NMR (121.5 MHz, CDCl₃): σ 46.98 (S), 73.46 (S)
IR (KBr, cm⁻¹): 3261 (OH - Gruppe), 3058 (Aromatische C-H - Bindung), 2920 (C-H - Bindung), 1240 (Aromatische C-O-C Bindung)

### Ausführungsbeispiel 5

In einen Reaktor wurden 50.80 g eines Bisphenol-A - Epoxyharzes (Epototo YD-128, hergestellt von Tohto Kasei Co., Ltd., mit einem Epoxyäquivalent von 186.6 g / Äquivalent) gegeben. Der Reaktor wurde dann auf 80 °C erhitzt. In den resultierenden Reaktor wurden 11.69 g der im Herstellungsbeispiel 1 hergestellten Mischung, die 1,4-Cyclooktylenphosphinoxid und 1,5-Cyclooktylenphosphinoxid enthielt, gegeben. Anschließend wurden 0.023 g Triphenylphosphin, das als Katalysator fungiert, in den Reaktor gegeben, während die Mischung im Reaktor gerührt wurde. Der Reaktor wurde dann auf 150 °C erhitzt. Nach 30 Minuten hatte sich im Reaktor eine durchsichtige Schmelze gebildet. Es wurde noch für acht weitere Stunden umgerührt und der Reaktor dann gekühlt, wodurch ein weißer Feststoff erhalten wurde. Der Feststoff wurde in einem Mörser zerstoßen, wodurch 61.6 g weißes Pulver erhalten wurde. Das weiße Pulver war ein Phosphor enthaltendes Epoxyharz (im Folgenden als Harz E bezeichnet), das ein Epoxyäquivalent von 330.8 g / Äquivalent und einen Phosphorgehalt von 3.6 Gew.-% hatte.

Auf die gleiche Weise wie oben wurde auch das in anderen Beispielen benutzte Harz E hergestellt.
³¹P NMR (121.5 MHz, CDCl₃): σ 46.69 (S), 73.00 (S)
IR (KBr, cm⁻¹): 3265 (OH - Gruppe), 3056 (Aromatische C-H - Bindung), 2924 (C-H - Bindung), 1247 (Aromatische C-O-C - Bindung)

Tabelle 1 zeigt die in den obigen Beispielen verwendeten Zutaten.

**Tabelle 1 : Phosphor enthaltendes Epoxyharz**

| Harz | Beispiel | Epoxyharz | Sekundäre Phosphinderivative (Flammschutzmittel) | Katalysator |
|---|---|---|---|---|
| A | 1 | 120.0 g Epototo YDCN-701 | 22.72 g einer Mischung von 1,4-Cyclooktylenphosphinoxid und 1,5-Cyclooktylenphosphinoxid | 0.047 g Triphenylphosphin |
| B | 2 | 30.45 g Epototo YDPN-638 | 6.08 g einer Mischung von 1,4-Cyclooktylenphosphinoxid und 1,5-Cyclooktylenphosphinoxid | 0.024 g Triphenylphosphin |
| C | 3 | 40.02 g Epototo YDCN-701 und 25.80 g Epototo YD-128 | 11.42 g einer Mischung aus 1,4-Cyclooktylenphosphinoxid und 1,5-Cyclooktylenphosphinoxid | 0.024 g Triphenylphosphin |
| D | 4 | 57.00 g Epototo YDPN-638 | 4.68 g einer Mischung von 1,4-Cyclooktylenphosphinoxid und 1,5-Cyclooktylenphosphinoxid | 0.024 g Triphenylphosphin |
| E | 5 | 50.80 g Epototo YD-128 | 11.69 g einer Mischung von 1,4-Cyclooktylenphosphinoxid und 1,5-Cyclooktylenphosphinoxid | 0.023 g Triphenylphosphin |

### Ausführungsbeispiel 6

Eine pulverige, Phosphor enthaltende Epoxyharz-Zusammensetzung wurde durch Mischen von 5.0 g des in Ausführungsbeispiel 2 hergestellten Harzes B, 0.19 g Dicyandiamid, das als Härtungsmittel fungiert, und 0.05 g 2-Ethyl-4-Methylimidazol, das als Härtungsbeschleuniger fungiert, hergestellt.

### Ausführungsbeispiel 7

Das folgende Harz und die folgenden Verbindungen wurden vollständig gemischt: 100.0 g des in Ausführungsbeispiel 2 hergestellten Harzes B, 3.8 g Dicyandiamid, das als Härtungsmittel fungiert, und 0.05 g 2-Ethyl-4-Methylimidazol, das als Härtungsbeschleuniger fungiert. Die Mischung wurde in eine Teflon™ ― Form mit den Abmessungen 200 mm × 200 mm × 2 mm platziert und dann bei 180 °C für fünf Stunden in einem Trocknungsofen getrocknet, wodurch ein gehärteter Körper aus einem Phosphor enthaltenden Epoxyharz erhalten wurde. Der gehärtete Körper wurde zu Teststücken mit einer Länge von 127 mm, einer Breite von 12.7 mm und einer Dicke von 2 mm verarbeitet. Eines der Teststücke wurde mit einer DSC-Methode analysiert. Die Analyse zeigte, dass das Teststück einen Glasübergangspunkt von 149.6 °C hatte.

### Ausführungsbeispiel 8

Eine flüssige, Phosphor enthaltende Epoxyharz-Zusammensetzung wurde durch Mischung von 5.03 g des in Ausführungsbeispiel 2 erhaltenen Harzes B, 2.08 g eines Bisphenol-A - Epoxyharzes (Epototo YD-128, hergestellt von Tohto Kasei Co., Ltd., mit einem Epoxyäquivalent von 186.6 g / Äquivalent), 0.30 g Dicyandiamid, das als Härtungsmittel fungiert, und 0.04 g 2-Ethyl-4-methylimidazol, das als Härtungsbeschleuniger fungiert, hergestellt.

### Ausführungsbeispiel 9

Das folgende Harz und die folgenden Verbindungen wurden vollständig gemischt: 100.6 g des in Ausführungsbeispiel 2 hergestellten Harzes B, 41.6 g eines Bisphenol-A - Epoxyharzes (Epototo YD-128, hergestellt von Tohto Kasei Co., Ltd., das ein Epoxyäquivalent von 186.6 g / Äquivalent hatte), 6.0 g Dicyandiamid, das als Härtungsmittel fungiert, und 0.04 g 2-Ethyl-4-methylimidazol, das als Härtungsbeschleuniger fungiert. Die Mischung wurde in eine Teflon™ - Form mit den Abmessungen 200 mm x 200 mm x 2 mm platziert und dann bei 180 °C für fünf Stunden in einem Trocknungsofen getrocknet, wodurch ein gehärteter Körper aus einem Phosphor enthaltenden Epoxyharz erhalten wurde. Der gehärtete Körper wurde zu Teststücken mit einer Länge von 127 mm, einer Breite von 12.7 mm und einer Dicke von 2 mm verarbeitet. Eines der Teststücke wurde mit einer DSC-Methode analysiert. Die Analyse zeigte, dass das Teststück einen Glasübergangspunkt bei 146.4 °C hatte.

### Ausführungsbeispiel 10

Harzlack wurde durch Auflösung des folgenden Harzes und der folgenden Verbindungen in 72 g einer Lösungsmittelmischung aus N,N-Dimethylformamid und Methylethylketon hergestellt: 70.1 g des in Ausführungsbeispiel 1 hergestellten Harzes A, 2.2 g Dicyandiamid, das als Härtungsmittel fungiert, und 0.04 g 2-Ethyl-4-methylimidazol, das als Härtungsbeschleuniger fungiert. Blätter von Glasgewebe (WEA 7628, hergestellt von Nitto Boseki Co., Ltd., mit einer Dicke von 0.18 mm) wurden mit dem erhaltenen Lackharz imprägniert. Die resultierenden Blätter wurden bei 150 °C für zehn Minuten in einem Ofen mit heißender zirkulierender Luft getrocknet, wodurch Prepregs mit einem Harzgehalt von 42.6 Gew.-% hergestellt wurden. Acht der erhaltenen Prepregs wurden übereinander gestapelt und die gestapelten Prepregs bei 170 °C für zwei Stunden mit einer Kraft von 40 kgf / cm² heißgepresst, wodurch ein Laminat hergestellt wurde. Das Laminat wurde mit einer TMA - Methode analysiert. Die Analyse zeigte, dass das Laminat einen Glasübergangspunkt von 167.6 °C hatte.

### Ausführungsbeispiel 11

Harzlack wurde durch Auflösung des folgenden Harzes und der folgenden Verbindungen in 83 g einer Lösungsmittelmischung aus N,N-Dimethylformamid und Methylethylketon hergestellt: 50.0 g des in Ausführungsbeispiel 1 hergestellten Harzes A, 30.0 g Bisphenol-A - Epoxyharz (Epototo YD-128, hergestellt von Tohto Kasei Co., Ltd., das ein Epoxyäquivalent von 186.6 g / Äquivalent aufwies), 3.38 g Dicyandiamid, das als Härtungsmittel fungiert, und 0.04 g 2-Ethyl-4-methylimidazol, das als Härtungsbeschleuniger fungiert. Blätter von Glasgewebe (WEA 7628, hergestellt von Nitto Boseki Co., Ltd., mit einer Dicke von 0.18 mm) wurden mit dem erhaltenen Harzlack imprägniert. Die resultierenden Blätter wurden bei 150 °C für sechs Minuten in einem Ofen mit heißer zirkulierender Luft getrocknet, wodurch Prepregs mit einem Harzgehalt von 44.0 Gew.-% hergestellt wurden. Acht der erhaltenen Prepregs wurden aufgestapelt und die aufgestapelten Prepregs wurden bei 170 °C für zwei Stunden mit einer Kraft von 40 kgf / cm² heißgepresst, wodurch ein Laminat hergestellt wurde. Das Laminat wurde mit einer TMA-Methode analysiert. Die Analyse zeigte, dass das Laminat einen Glasübergangspunkt von 174.8 °C hatte.

### Ausführungsbeispiel 12

Harzlack wurde durch Auflösung des folgenden Harzes und der folgenden Komponenten in 83 g eines Lösungsmittelgemisches aus N,N-Dimethylformamid und Methylethylketon hergestellt: 49.8 g des in Ausführungsbeispiel 2 hergestellten Harzes A, 10.1 g eines Bisphenol-A - Epoxyharzes (Epototo YD-128, hergestellt von Tohto Kasei Co., Ltd., mit einem Epoxyäquivalent von 186.6 g / Äquivalent), 22.4 g eines Novolak-Phenol-Harzes (PSM-4261, hergestellt von Gun Ei Chemical Industry Co., Ltd., mit einem Hydroxyläquivalent von 104 bis 106 g / Äquivalent), das als Härtungsmittel fungiert, und 0.04 g 2-Ethyl-4-methylimidazol, das als Härtungsbeschleuniger fungiert. Blätter von Glasgewebe (WEA 7628, hergestellt von Nitto Boseki Co., Ltd., mit einer Dicke von 0.18 mm) wurden mit dem erhaltenen Harzlack imprägniert. Die resultierenden Blätter wurden bei 150 °C für sieben Minuten in einem Ofen mit heißer zirkulierender Luft getrocknet, wodurch Prepregs mit einem Harzgehalt von 46.2 Gew.-% hergestellt wurden. Acht der erhaltenen Prepregs wurden gestapelt und die gestapelten Prepregs wurden bei 170 °C für zwei Stunden mit einer Kraft von 40 kgf / cm² heißgepreßt, wodurch ein Laminat hergestellt wurde. Das Laminat wurde mit einer TMA-Methode analysiert. Die Analyse zeigte, dass das Laminat einen Glasübergangspunkt von 161.2 °C hatte.

### Ausführungsbeispiel 13

Harzlack wurde hergestellt, indem das folgende Harz und die folgenden Verbindungen in 93 g einer Lösungsmittelmischung von N,N-Dimethylformamid und Methylethylketon aufgelöst wurden: 70.0 g des im Ausführungsbeispiel 1 hergestellten Harzes A, 23.8 g eines Novolak-Phenol-Harzes (PSM-4261, hergestellt von Gun Ei Chemical Industry Co., Ltd., mit einem Hydroxyläquivalent von 104 bis 106 g / Äquivalent), das als Härtungsmittel fungiert, und 0.05 g 2-Ethyl-4-Methylimidazol, das als Härtungsbeschleuniger fungiert. Blätter von Glasgewebe (WEA 7628, hergestellt von Nitto Boseki Co., Ltd., mit einer Dicke von 0.18 mm) wurden mit dem oben erhaltenen Lackharz imprägniert. Die erhaltenen Blätter wurden bei 150 °C für sieben Minuten in einem Ofen mit heißer zirkulierender Luft getrocknet, wodurch Prepregs mit einem Harzgehalt von 46.7 Gew.-% hergestellt wurden. Acht der erhaltenen Prepregs wurden gestapelt und die gestapelten Prepregs wurden bei 170 °C für zwei Stunden mit einer Kraft von 40 kgf / cm² heißgepresst, wodurch ein Laminat hergestellt wurde. Das Laminat wurde mit einer TMA-Methode analysiert. Die Analyse zeigte, dass das Laminat einen Glasübergangspunkt von 163.5 °C hatte.

### Ausführungsbeispiel 14

Harzlack wurde durch Auflösen des folgenden Harzes und der folgenden Verbindungen in 73 g einer Lösungsmittelmischung von N,N-Dimethylformamid und Methylethylketon hergestellt: 70.3 g des in Ausführungsbeispiel 3 hergestellten Harzes C, 2.6 g Dicyandiamid, das als Härtungsmittel fungiert, und 0.04 g 2-Ethyl-4-methylimidazol, das als Härtungsbeschleuniger fungiert. Blätter von Glasgewebe (WEA 7628, hergestellt von Nitto Boseki Co., Ltd., mit einer Dicke von 0.18 mm) wurden mit dem erhaltenen Harzlack imprägniert. Die resultierenden Blätter wurden bei 150 °C für zehn Minuten in einem Ofen mit heißer zirkulierender Luft getrocknet, wodurch Prepregs mit einem Harzgehalt von 40.0 Gew.-% hergestellt wurden. Acht der erhaltenen Prepregs wurden gestapelt und die gestapelten Prepregs wurden bei 170°C für zwei Stunden mit einer Kraft von 40 kgf / cm² heißgepresst, wodurch ein Laminat hergestellt wurde. Das Laminat wurde mit einer TMA-Methode analysiert. Die Analyse zeigte, dass das Laminat einen Glasübergangspunkt von 135.2 °C hatte.

### Ausführungsbeispiel 15

Harzlack wurde hergestellt, indem das folgende Harz und die folgenden Verbindungen in 72 g einer Lösungsmittelmischung von N,N-Dimethylformamid und Methylethylketon aufgelöst wurden: 68.1 g des in Ausführungsbeispiel 4 hergestellten Harzes D, 3.5 g Dicyandiamid, das als Härtungsmittel fungiert, und 0.04 g 2-Ethyl-4-methylimidazol, das als Härtungsbeschleuniger fungiert. Blätter von Glasgewebe (WEA 7628, hergestellt von Nitto Boseki Co., Ltd., mit einer Dicke von 0.18 mm) wurden mit dem erhaltenen Harzlack imprägniert. Die resultierenden Blätter wurden bei 150°C für zehn Minuten in einem Ofen mit heißer zirkulierender Luft getrocknet, wodurch Prepregs mit einem Harzgehalt von 42.1 Gew.-% hergestellt wurden. Acht der erhaltenen Prepregs wurden gestapelt und die gestapelten Prepregs wurden bei 170 °C für zwei Stunden mit einer Kraft von 40 kgf / cm² in der Hitze gepresst, wodurch ein Laminat hergestellt wurde. Das Laminat wurde mit einer TMA-Methode analysiert. Die Analyse zeigte, dass das Laminat einen Glasübergangspunkt von 151.0°C hatte.

### Ausführungsbeispiel 16

Harzlack wurde durch Auflösen des folgenden Harzes und der folgenden Verbindungen in 87 g einer Lösungsmittelmischung aus N,N-Dimethylformamid und Methylethylketon hergestellt: 49.2 g des in Ausführungsbeispiel 4 hergestellten Harzes D, 31.0 g eines Bisphenol-A - Epoxyharzes (Epototo YD-128, hergestellt von Tohto Kasei Co., Ltd., das ein Epoxyäquivalent von 186.6 g / Äquivalent hat), 5.2 g Dicyandiamid, das als Härtungsmittel fungiert und 0.04 g 2-Ethyl-4-Methylimidazol, das als Härtungsbeschleuniger fungiert. Blätter von Glasgewebe ("glass cloth") (WEA 7628, hergestellt von Nitto Boseki Co., Ltd., mit einer Dicke von 0.18 mm) wurden mit dem erhaltenen Harzlack imprägniert. Die resultierenden Blätter wurden bei 150°C für zehn Minuten in einem Ofen mit heißer zirkulierender Luft getrocknet, wodurch Prepregs mit einem Harzgehalt von 42.7 Gew.-% hergestellt wurden. Acht der erhaltenen Prepregs wurden gestapelt und die gestapelten Prepregs wurden bei 170 °C während zwei Stunden mit einer Kraft von 40 kgf/cm² heißgepresst, wodurch ein Laminat hergestellt wurde. Das Laminat wurde mit einer TMA-Methode analysiert. Die Analyse zeigte, dass das Laminat einen Glasübergangspunkt von 152.8 °C hatte.

### Ausführungsbeispiel 17

Harzlack wurde durch Auflösen des folgenden Harzes und der folgenden Verbindungen in 68 g einer Lösungsmittelmischung aus N,N-Dimethylformamid und Methylethylketon hergestellt: 34.2 g des in Ausführungsbeispiel 5 hergestellten Harzes E, 30.8 g eines o-Kresolnovolak-Epoxyharzes (Epototo YDCN-701, hergestellt durch Tohto Kasei Co., Ltd., mit einem Epoxyäquivalent von 200.2 g / Äquivalent), 2.7 g Dicyandiamid, das als Härtungsmittel fungiert, und 0.05 g 2-Ethyl-4-Methylimidazol, das als Härtungsbeschleuniger fungiert. Blätter von Glasgewebe (WEA 7628, hergestellt von Nitto Boseki Co., Ltd., mit einer Dicke von 0.18 mm) wurden mit dem erhaltenen Harzlack imprägniert. Die erhaltenen Blätter wurden bei 150 °C für Minuten in einem Ofen mit heißer zirkulierender Luft getrocknet, wodurch Prepregs mit einem Harzgehalt von 49.7 Gew.-% hergestellt wurden. Acht der erhaltenen Prepregs wurden gestapelt und die gestapelten Prepregs wurden bei 170 °C für zwei Stunden mit einer Kraft von kgf / cm² heißgepresst, wodurch ein Laminat hergestellt wurde. Das Laminat wurde mit einer TMA-Methode analysiert. Die Analyse zeigte, dass das Laminat einen Glasübergangspunkt von 119.4 °C hatte.

### Vergleichsbeispiel 1

Das folgende Harz und folgende Verbindung wurden gemischt: 300 g Bisphenol-A-Epoxyharz (Epikote 828, hergestellt von Yuka Shell Epoxy KK, mit einem Epoxyäquivalent von 184 bis 194 g / Äquivalent) und 53 g m-Xylylendiamin, das als Härtungsmittel fungiert. Außerdem wurden zu der obigen Mischung auch 10 Gew.-%, bezogen auf die Menge der obigen Mischung, Trikresylphosphat gegeben. Die erhaltene Mischung wurde bei Raumtemperatur für drei Stunden gehärtet und dann bei 100 °C für zwei Stunden gehärtet, wodurch ein gehärteter Körper auf der Basis von Epoxyharz erhalten wurde.

### Flammschutztest

Die in den Ausführungbeispielen 7 und 9 hergestellten gehärteten Körper wurden zu Teststücken mit einer Länge von 125 mm, einer Breite von 13 mm und einer Dicke von 2 mm verarbeitet. Die in den Ausführungsbeispielen 10 bis 17 hergestellten Laminate wurden zu Teststücken mit einer Länge von 125 mm, einer Breite von 13 mm und einer Dicke von 1.5 mm verarbeit. Um die Flammwidrigkeit zu beurteilen, wurden diese Teststücke dem vertikalen Flammentest von UL-94 unterzogen, der drei Einstufungen kennt: 94V-0, 94V-1 und 94V-2. Die Testergebnisse sind in Tabelle 2 gezeigt.

**Tabelle 2 : Ergebnisse des Flammschutrtestes**

| Beispiele | Phosphorgehalt (Gew.-%) | Glasübergangspunkt(°C) | UL-94 |
|---|---|---|---|
| 7 | 3.0 | 149.6 | V-0 |
| 9 | 2.1 | 146.4 | V-0 |
| 10 | 1.3 | 167.6 | V-0 |
| 11 | 0.8 | 174.8 | V-0 |
| 12 | 0.8 | 161.2 | V-0 |
| 13 | 1.0 | 163.5 | V-0 |
| 14 | 1.1 | 135.2 | V-0 |
| 15 | 0.5 | 151.0 | V-1 |
| 16 | 0.3 | 152.8 | V-1 |
| 17 | 0.9 | 119.4 | V-0 |

### Test der chemischen Beständigkeit

Die zwei in Ausführungsbeispiel 7 und Vergleichsbeispiel 1 hergestellten gehärteten Körper wurden gemäß der Methode JIS K 7114 auf chemische Beständigkeit untersucht.

Die gehärteten Körper wurden jeweils zu fünf scheibenförmigen Teststücken verarbeitet, die einen Durchmesser von 50 mm und eine Dicke von 2 mm hatten. Die Teststücke wurden für sieben Tage bei 23 °C in Schwefelsäure getaucht, die eine Dichte von 10 Gew.-% hatte. Die resultierenden Teststücke wurden ausreichend mit Wasser gewaschen, bei 90 °C unter reduziertem Druck für einen Tag getrocknet und dann in Hinblick auf Gewicht und Aussehen untersucht.

Das Testergebnis zeigte, dass die Teststücke von Ausführungsbeispiel 7 im Durchschnitt eine Gewichtsverringerung von 1.5 % eingingen und im Aussehen nicht verändert waren. Im Gegensatz hierzu war das Gewicht bei den Teststücken von Vergleichsbeispiel 1 im Durchschnitt um 10 Prozent oder mehr verringert und die Teststücke hatten ein weißliches Aussehen, wobei die Teststücke unter Verwendung des Harzes Epikote 828 und von Trikresylphosphat wie oben beschrieben hergestellt worden waren. Dieser Unterschied ist vermutlich auf folgenden Umstand zurückzuführen: der gehärtete Körper von Ausfürhrungsbeispiel 7 enthält Phosphoratome, die jeweils direkt an entsprechende Kohlenstoffatome gebunden sind, um P-C - Bindungen zu bilden, die stabil sind, und weist daher eine hohe chemische Beständigkeit auf. Jedoch enthält der gehärtete Körper von Vergleichsbeispiel 1 Phosphoratome, die jeweils indirekt an entsprechende Kohlenstoffatome gebunden sind, wobei entsprechende Sauerstoffatome dazwischen angeordnet sind, um P-O-C - Bindungen zu bilden, die bereitwillig hydrolysiert werden und hat daher eine unterlegene chemische Beständigkeit, weil Phosphorsäure aus dem gehärteten Körper eluiert wird. Daher wurde bei den Teststücken von Vergleichsbeispiel 1 das Gewicht deutlich verringert und das Aussehen wurde weißlich.

### Ausführungsbeispiel 18

Das folgende Harz und die folgenden Verbindungen wurden bei Raumtemperatur mit einem Mischer gemischt: 180.4 Gewichtsteile des in Ausführungsbeispiel 1 hergestellten Phosphor enthaltenden Epoxyharzes, 61.50 Gewichtsteile eines Novolak-Phenol-Harzes (PSM-4261, hergestellt von Gun Ei Chemical Industry Co., Ltd.), 2.26 Gewichtsteile Triphenylphosphin, hergestellt von Hokko Chemical Industry Co., Ltd., 1.13 Gewichtsteile OP - Wachs, hergestellt von Hoechst Marion Roussell, 1.13 Gewichtsteile Kohleschwarz, hergestellt von Mitsubishi Chemical Corporation, und 820.0 Gewichtsteile Quarzglas (Silstar M2430, hergestellt von Nippon Chemical Industrial Co., Ltd.). Die Mischung wurde bei 80 °C bis 85°C für sieben Minuten mit einem heißen Doppelschneckenroller ("twin-screw roll") geknetet. Die resultierende Mischung wurde von der Rolle abgezogen, gekühlt und dann gebrochen, wodurch ein Epoxyharz-Dichtungsmittel hergestellt wurde.

Eine flache Packung mit 80 Stiften ("80-pin"), welches auf sich den folgenden Chip enthält, wurde durch ein Transferformverfahren ("transfer molding process") unter Verwendung des Dichtungsmittels hergestellt: ein Test - Siliziumchip mit den Abmessungen 6 mm x 6 mm x 0.4 mm, der mit Aluminiumdrähten ausgerüstet ist, die eine Breite von 10 µm und eine Dicke von 1 µm haben. Die flache Packung hatte externe Abmessungen von 19 mm x 14 mm x 2.7 mm.

### Ausführungsbeispiel 19

Das folgende Harz und die folgenden Verbindungen wurden bei Raumtemperatur mit einem Mischer gemischt: 163.3 Gewichtsteile des in Ausführungsbeispiel 2 hergestellten, Phosphor enthaltenden Epoxyharzes, 61.50 Gewichtsteile eines Novolak-Phenolharzes (PSM-4261, hergestellt von Gun Ei Chemical Industry Co., Ltd.), 2.26 Gewichtsteile Triphenylphosphin, hergestellt von Hokko Chemical Industry Co., Ltd., 1.13 Gewichtsteile OP - Wachs, hergestellt von Hoechst Marion Russell, 1.13 Gewichtsteile Kohleschwarz, hergestellt von Mitsubishi Chemical Corporation, und 820.0 Gewichtsteile Quarzglas (Silstar M2430, hergestellt von Nippon Chemical Industrial Co., Ltd.). Die Mischung wurde bei 80 °C bis 85 °C für sieben Minuten mit einer heißen Doppelschnecken-Rolle geknetet. Die resultierende Mischung wurde von der Rolle abgelöst, gekühlt und dann gebrochen, wodurch ein Epoxyharz-Dichtungsmittel hergestellt wurde.

Eine flache Packung mit 80 Stiften ("80-pin"), welches auf sich den folgenden Chip enthält, wurde durch ein Transferformverfahren ("transfer molding process") unter Verwendung des Dichtungsmittels hergestellt: ein Test - Siliziumchip mit den Abmessungen 6 mm x 6 mm x 0.4 mm, der mit Aluminiumdrähten ausgerüstet ist, die eine Breite von 10 µm und eine Dicke von 1 µm haben. Die flache Packung hatte externe Abmessungen von 19 mm x 14 mm x 2.7 mm.

## Patentansprüche

1. Ein Phosphor enthaltendes Epoxyharz, welches umfasst:
eine strukturelle Einheit, die sich ableitet von einem sekundären Phosphinderivat, das durch die folgende Formel dargestellt wird: 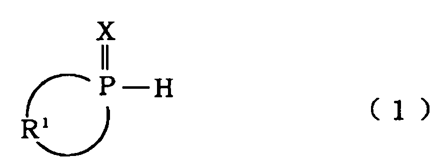
oder 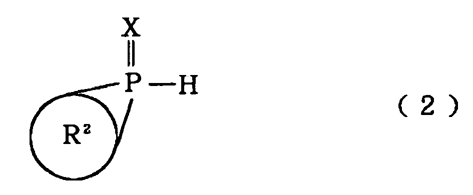
worin R¹ eine Alkylengruppe bedeutet, die drei bis neun Kohlenstoffatome hat und außerdem einen Substituenten aufweisen kann, R² eine Cycloalkylen- oder Arylengruppe bedeutet, wobei die Cycloalkylengruppe vier bis neun Kohlenstoffatome hat, R² außerdem einen Substituenten aufweisen kann, und X ein Sauerstoff- oder Schwefelatom bedeutet.

2. Das Phosphor enthaltende Epoxyharz gemäß Anspruch 1, worin das sekundäre Phosphinderivat mindestens eines ist, das aus 1,4-Cyclooktylenphosphinoxid und 1,5-Cyclooktylenphosphinoxid ausgewählt ist.

3. Das Phosphor enthaltende Epoxyharz gemäß Anspruch 1 oder 2, worin dem sekundären Phosphinderivat ermöglicht wird, mit einer Epoxy- oder Polyepoxyverbindung zu reagieren, wodurch das Harz erhalten wird.

4. Das Phosphor enthaltende Epoxyharz nach einem der Ansprüche 1 bis 3, worin der Phosphorgehalt 0.1 Gew.-% bis 10 Gew.-% beträgt.

5. Eine Phosphor enthaltende Epoxyharzzusammensetzung, enthaltend:
das Phosphor enthaltende Epoxyharz nach einem der Ansprüche 1 bis 4; und ein Härtungsmittel oder einen Polymerisationsinitiator.

6. Ein Verfahren zur Herstellung eines Phosphor enthaltenden Epoxyharzes, umfassend:
einen Schritt, in dem einer Epoxy- oder Polyepoxyverbindung die Reaktion mit einem sekundären Phosphin-Derivat, das durch die folgende Formel dargestellt wird, ermöglicht wird: 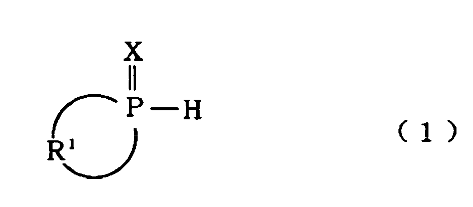 oder 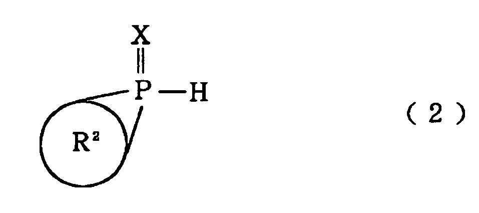
worin R¹ eine Alkylengruppe bedeutet, die drei bis neun Kohlenstoffatome hat und außerdem einen Substituenten aufweisen kann, R² eine Cycloalkylen- oder Arylengruppe bedeutet, wobei die Cycloalkylengruppe vier bis neun Kohlenstoffatome hat, R² außerdem einen Substituenten enthalten kann, und X ein Sauerstoff- oder Schwefelatom bedeutet.

7. Ein Dichtungsmittel, das die Phosphor enthaltende Epoxyharz-Zusammensetzung nach Anspruch 5 enthält.

8. Ein Formmaterial, das die Phosphor enthaltende Epoxyharz-Zusammensetzung nach Anspruch 5 enthält.

9. Ein Laminat, das die Phosphor enthaltende Epoxyharz-Zusammensetzung nach Anspruch 5 enthält.

## Claims

1. A phosphorus-containing epoxy resin comprising:
a structural unit derived from a secondary phosphine derivative represented by the following formula: 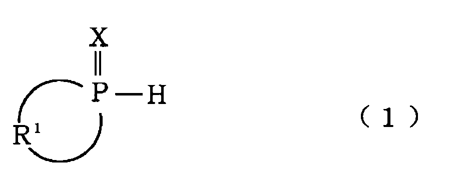 or 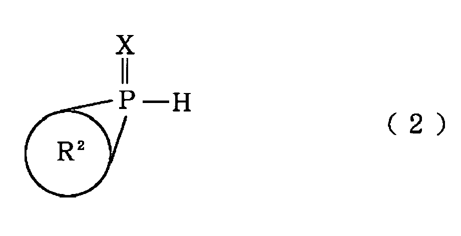
wherein R¹ represents an alkylene group which has three to nine carbon atoms and may have furthermore a substituent, R² represents a cycloalkylene or arylene group, wherein the cycloalkylene group has four to nine carbon atoms, wherein R² may furthermore have a substituent, and X represents an oxygen or sulfur atom.

2. The phosphorus-containing epoxy resin according to Claim 1, wherein the secondary phosphine derivative is at least one selected from 1,4-cyclooctylenephosphine oxide and 1,5-cyclooctylenephosphine oxide.

3. The phosphorus-containing epoxy resin according to Claim 1 or 2, wherein the secondary phosphine derivative is allowed to react with an epoxy or polyepoxy compound, whereby the resin is obtained.

4. The phosphorus-containing epoxy resin according to any one of Claims 1 to 3, wherein the phosphorus content is 0.1 percent to 10 percent by weight.

5. A phosphorus-containing epoxy resin composition containing:
the phosphorus-containing epoxy resin according to any one of Claims 1 to 4; and a curing agent or a polymerization initiator.

6. A process for producing a phosphorus-containing epoxy resin comprising:
a step of allowing an epoxy or polyepoxy compound to react with a secondary phosphine derivative represented by the following formula: 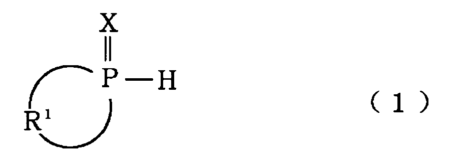
or 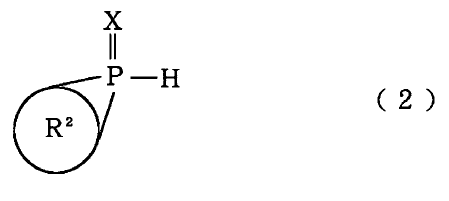
wherein R¹ represents an alkylene group which has three to nine carbon atoms and may have furthermore a substituent, R² represents a cycloalkylene or arylene group, wherein the cycloalkylene group has four to nine carbon atoms, where R² may furthermore have a substituent, and X represents an oxygen or sulfur atom.

7. A sealant containing the phosphorus-containing epoxy resin composition according to Claim 5.

8. A molding material containing the phosphorus-containing epoxy resin composition according to Claim 5.

9. A laminate containing the phosphorus-containing epoxy resin composition according to Claim 5.

## Revendications

1. Une résine époxy contenant du phosphore comprenant:
une unité structurelle dérivée d'un dérivé phosphine secondaire représenté par la formule suivante: 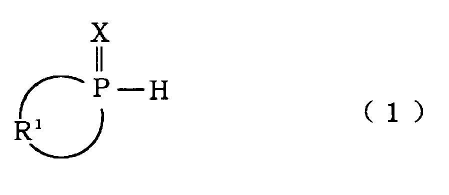 ou 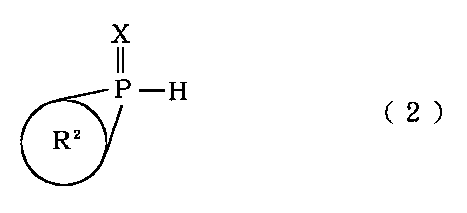 dans laquelle R¹ représente un groupe alkylène comportant 3 à 9 atomes de carbone et pouvant avoir de surcroît un substituant , R² représente un groupe arylène ou cycloalkylene dans lequel le groupe cycloalkylene comporte 4 à 9 atomes et où R² peut avoir de surcroît un substituant, et X représente un atome d'oxygène ou de soufre.

2. La résine époxy contenant du phosphore selon la revendication 1, dans laquelle le dérivé phosphine secondaire est au moins un dérivé choisi entre l'oxyde 1,4-cyclooctylènephosphine et l'oxyde 1,5-cyclooctylènephosphine.

3. La résine époxy contenant du phosphore selon la revendication 1 ou 2 dans laquelle le dérivé phosphine secondaire peut réagir avec un composé époxy ou polyépoxy, grâce à quoi la résine est obtenue.

4. La résine époxy contenant du phosphore selon l'une des revendications 1 à 3, dans laquelle le contenu en phosphore est de 0.1 à 10 % en poids.

5. Une résine époxy contenant du phosphore comprenant:
la résine époxy contenant du phosphore selon l'une des revendications 1 à 4; et un agent durcissant ou un initiateur de polymérisation.

6. Une procédé pour produire de la résine époxy contenant du phosphore comprenant:
une étape permettant au composé époxy ou polyépoxy de réagir avec un dérivé phosphine secondaire représenté par la formule suivante: 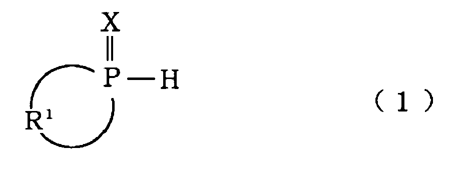 ou 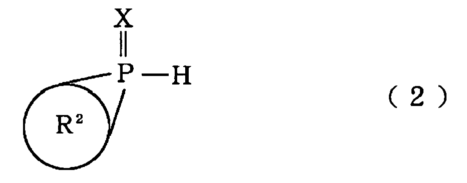
dans laquelle R¹ représente un groupe alkylène ayant 3 à 9 atomes de carbone et pouvant avoir de surcroît un substituant , R² représente un groupe arylène ou cycloalkylène, dans lequel le groupe cycloalkylène comporte 4 à 9 atomes de carbone et où R² peut avoir de surcroît un substituant, et X représente un atome d'oxygène ou de soufre.

7. Un enduit d'étanchéité comportant la composition de résine époxy contenant du phosphore selon la revendication 5.

8. Un matériau de moulage comportant la composition de résine époxy contenant du phosphore selon la revendication 5.

9. Un stratifié d'étanchéification comportant la composition de résine époxy contenant du phosphore selon la revendication 5.
